# EUROPEAN PATENT APPLICATION

(11) **EP 4 439 874 A1**
(43) Date of publication of application: **02.10.2024**
(21) Application number: 22897689.0
(22) Date of filing: 17.11.2022
(51) Int. Cl.: H01R 24/00, H01R 13/629, H01R 13/502, A01G 3/08, A01D 34/00, H01M 50/244, H01M 50/247, H01M 50/262, H05K 7/20

(54) **COUPLING APPARATUS AND BACKPACK GARDENING TOOL SYSTEM**

(30) Priority: 24.11.2021 CN 202122906990 U; 24.11.2021 CN 202122911134 U; 13.05.2022 CN 202221164034 U
(71) Applicant: Globe (Jiangsu) Co., Ltd., Changzhou, Jiangsu 213023 (CN)
(72) Inventor: TANG, Yabin, hangzhou, Jiangsu 213023 (CN); SHANGGUAN, Yunjie, hangzhou, Jiangsu 213023 (CN)
(74) Representative: Bergenstråhle & Partners AB
(86) International application number: PCT/CN2022/132515
(87) International publication number: WO 2023/093606

(57) **Abstract**

The disclosure relates to a field of garden tools, specifically relates to a coupling device and a backpack garden tool system. The coupling device includes a first coupling unit and a second coupling unit. The first coupling unit is configured to be detachably connectable with a power supply output end of a backpack battery pack. The second coupling unit is connected with the first coupling unit through a flexible wire, and the second coupling unit is configured to be detachably connectable with a power input end of a first garden tool. The disclosure realizes a functional expansion of a backpack blower through the coupling device.

## Description

### CROSS REFERENCE TO RELATED APPLICATION

The present application is a continuation Application of PCT application No. PCT/CN2022/132515 filed on November 17, 2022, which claims the benefit of CN202122906990.3 filed on November 24, 2021, CN202122911134.7 filed on November 24, 2021, and CN202221164034.0 filed on May 13, 2022. All the above are hereby incorporated by reference for all purposes.

### TECHNICAL FIELD

The disclosure relates to a field of garden tools, specifically relates to a coupling device and a backpack garden tool system.

### BACKGROUND

A backpack garden tool includes a backpack battery pack and a tool body, the tool body may be a blower, a hedge trimmer, a string trimmer and so on. In the backpack garden tool of the prior art, a backpack battery pack can often only match one kind of garden tool, and the function is relatively single. Each garden tool needs to be equipped with a separate backpack battery pack, which causes that the device cost is increased.

A battery pack disassembly process in the prior art is more complex, especially when equipped with a plurality of battery packs, a series of separate operations such as unlocking, disassembly, mounting, locking and so on are required for each battery pack, which increase the labor intensity, and seriously affect the work efficiency.

The operating power of the backpack blower is high, which causes the circuit board to heat up quickly and the working temperature to be high. The conventional backpack blower generally cannot cool the circuit board, which results in the electronic components being in a high-temperature working state for a long time, and affecting the duration life of the blower.

### SUMMARY

The disclosure provides a coupling device and a backpack garden tool that can match one backpack battery pack with a variety of different garden tools, which improves versatility, and reduces cost of garden tools.

The disclosure provides the coupling device. The coupling device includes a first coupling unit and a second coupling unit.

The first coupling unit is configured to be detachably connectable with a power supply output end of a backpack battery pack.

The second coupling unit is connected with the first coupling unit through a flexible wire and configured to be detachably connectable with a power input end of a first garden tool.

In an embodiment of the disclosure, the first coupling unit includes a first housing, the first housing is provided with a first plug-in part, the first plug-in part is matched with a first receiving part arranged on the backpack battery pack, the first plug-in part is provided with a first terminal, and the first terminal is configured to be capable of contacting with a second terminal arranged in the first receiving part when the first plug-in part is inserted into the first receiving part.

In an embodiment of the disclosure, one of the first plug-in part and the first receiving part is provided with a first protruding part, the other one of the first plug-in part and the first receiving part is provided with a first inserting groove, and when the first protruding part is inserted into the first inserting groove, the first terminal is electrically connected with the second terminal.

In an embodiment of the disclosure, the first protruding part is provided with a first deadbolt matched with a first clamping groove arranged in the first inserting groove, the first deadbolt is movably connected with the first protruding part, a moving direction of the first deadbolt is perpendicular to an inserting direction of the first plug-in part and the first receiving part, the first deadbolt is configured to be switchable between two stations, in a station one, the first deadbolt protrudes from a surface of the first protruding part, and in a station two, the first deadbolt shrinks into an inside of the first protruding part.

In an embodiment of the disclosure, a first elastic unit is arranged between the first deadbolt and the first housing, the first elastic unit is configured such that an elastic force thereof is capable of driving the first deadbolt at the station two to be switched to the station one, the first housing is provided with an unlocking button, the unlocking button is in a transmission connection with the first deadbolt, and the unlocking button is configured to drive the first deadbolt at the station one to be switched to the station two when the unlocking button is pressed by an external force.

In an embodiment of the disclosure, the second coupling unit includes a second housing, the second housing is provided with a second receiving part, and a third terminal is arranged in the second receiving part.

The disclosure provides a backpack garden tool system. The backpack garden tool system includes a backpack battery pack, a second garden tool and a coupling device.

The second garden tool is detachably connectable with the power supply output end of the backpack battery pack.

The coupling device includes the first coupling unit and the second coupling unit.

The first coupling unit is replaceable with the second garden tool and detachably connectable with the power supply output end of the backpack battery pack.

The second coupling unit is connected with the first coupling unit through a flexible wire and configured to be detachably connectable with a power input end of a first garden tool.

In an embodiment of the disclosure, the backpack battery pack includes a backpack base, a battery pack compartment and a locking device.

The battery pack compartment is arranged on the backpack base and provided with a cavity to accommodate a battery pack.

The locking device is mounted on a side wall of the cavity, and configured to lock the battery pack in the cavity and release a lock of the battery pack so as to withdraw the battery pack from the cavity.

In an embodiment of the disclosure, the locking device includes a base, a movable part, a deadbolt, a first holding mechanism and a second holding mechanism.

The base is fixed in the battery pack compartment.

The movable part is movably connected with the base and movable relative to the base between a first position and a second position.

The deadbolt is movably connected with the movable part and movable relative to the movable part between a first station and a second station.

The first holding mechanism is arranged between the base and the movable part, and configured to be capable of holding the movable part in the first position and releasing the movable portion from the first position.

The second holding mechanism is arranged between the deadbolt and the movable part.

When the movable part is in the first position and the deadbolt is at the first station, an end of the deadbolt protrudes into the cavity from the side wall of the cavity, and when the movable part and deadbolt are in combinations of remaining positions and stations, the end of the deadbolt leaves the cavity;

The second holding mechanism is configured to be capable of holding the deadbolt at the first station, and when the deadbolt protrudes into the cavity and the end of the deadbolt is subjected to an external force that is vertically downward, the deadbolt is capable of overcoming constraints of the second holding mechanism to be switched to the station two.

In an embodiment of the disclosure, the movable part is hinged with the base, the first holding mechanism includes a blocking part slidably connected with the base, the blocking part is slidable between a holding station and a releasing station along a sliding direction, when the blocking part is at the holding station, the blocking part blocks the movable part at the first position to limit the movable part at the first position, and when the blocking part is at the releasing station, the blocking part leaves a swinging path of the movable part, so that the movable part is capable of swinging to the second position.

In an embodiment of the disclosure, a first elastic unit is arranged between the blocking part and the base, a releasing button is attached to the blocking part, the deadbolt is slidably connected with the movable part; and the second holding mechanism is a second elastic unit arranged between the deadbolt and the movable part.

In an embodiment of the disclosure, the second garden tool is a blower, and the blower includes an air duct, a driving module, an impeller, a cover casing, a first vent and a second vent.

The driving module is arranged in the air duct, and provided with an output shaft.

The impeller is arranged on the output shaft of the driving module, and rotates around an axis of the output shaft.

The cover casing accommodates an electronic component therein.

The first vent communicates an inner cavity of the cover casing with the air duct.

The second vent communicates the inner cavity of the cover casing with air.

In an embodiment of the disclosure, the air duct includes an air inlet and an air outlet, the first vent is arranged at the air inlet and communicates with the air inlet, the cover casing is mounted on an outer wall of the air duct and is provided with a common wall with the air duct, the first vent is formed on the common wall, the cover casing is located on a lower side of the air duct, and a drainage port is arranged at a bottom of the cover casing.

In an embodiment of the disclosure, the drainage port includes a first drainage port located below the first vent and a second drainage port arranged adjacent to the second vent, a first water baffle and a second water baffle are arranged in the cover casing, the electronic component is mounted between the first water baffle and the second water baffle, the first vent and the first drainage port are located on one side of the first water baffle opposite to the electronic component, the second vent and the second drainage port are located at one side of the second water baffle opposite to the electronic component, an upper end of the first water baffle is provided with a first air hole, an upper end of the second water baffle is provided with a second air hole, a heat dissipation block is provided in the cover casing, the electronic component is mounted at a lower end of the heat dissipation block, and the first air hole and the second air hole are located above two ends of the heat dissipation block.

Technical effects of some embodiments of the disclosure are that the disclosure realizes a functional expansion of a backpack blower through the coupling device. When need to use the blower, the blower may be directly connected with the backpack battery pack. When need to use other garden tools such as hedge trimmer or string trimmer, the blower is removed from the backpack battery pack, and then the coupling device of the disclosure is utilized to connect the garden tools with the backpack battery pack, which may realize a power supply of these garden tools. The disclosure reduces cost of garden tools and devices.

The disclosure has realized a rapid mounting and disassembly of the battery pack through a cooperative matching of the movable part and the deadbolt, which improves battery replacement efficiency of the garden tools, and then improves work efficiency. In addition, a plurality of battery packs of the disclosure shares one locking device, which realizes a one-key release of the plurality of battery packs, further improves the battery replacement efficiency, and reduces labor intensity. The disclosure utilizes an insertion and ejection action of the battery pack itself to realize a switching between different states of the locking device, and simplifies a device structure and operation process.

The disclosure communicates a position where the electronic component is located with the air duct of the blower. When the blower works, air flow can be generated around the electronic component, and then take away heat generated by the electronic component, which has a cooling effect, and improves the duration life of the blower. In addition, the disclosure is provided with the water baffle and the drainage port in the cover casing, which can prevent the electronic component from being short-circuited or corroded when the blower is operating in a rainy day.

### BRIEF DESCRIPTION OF THE DRAWINGS

FIG. 1 is a perspective view of a backpack blower according to at least one embodiment of the disclosure.
FIG. 2 is a perspective view of the backpack blower in another state according to at least one embodiment of the disclosure.
FIG. 3 is a perspective view of a backpack battery pack according to at least one embodiment of the disclosure.
FIG. 4 is a partial exploded view of the backpack battery pack according to at least one embodiment of the disclosure.
FIG. 5 is a side view of the backpack battery pack according to at least one embodiment of the disclosure.
FIG. 6 is a cross-sectional view along a B-B direction in FIG. 5.
FIG. 7 is a partial perspective view of a blower according to at least one embodiment of the disclosure.
FIG. 8 is a partial exploded view of the blower according to at least one embodiment of the disclosure.
FIG. 9 is a partial side view of the blower according to at least one embodiment of the disclosure.
FIG. 10 is a cross-sectional view along a C-C direction in FIG. 9.
FIG. 11 is a perspective view of a coupling device according to at least one embodiment of the disclosure.
FIG. 12 is a perspective view of the coupling device from another angle according to at least one embodiment of the disclosure.
FIG. 13 is an internal schematic structural view of a first coupling unit according to at least one embodiment of the disclosure.
FIG. 14 is a schematic view of a usage scenario of the coupling device according to at least one embodiment of the disclosure.
FIG. 15 is a perspective schematic structural view of the backpack blower according to at least one embodiment of the disclosure.
FIG. 16 is a perspective schematic structural view of a backpack battery pack compartment according to at least one embodiment of the disclosure.
FIG. 17 is a top view of the backpack battery pack compartment according to at least one embodiment of the disclosure.
FIG. 18 is a cross-sectional view along an A-A direction in FIG. 17.
FIG. 19 is a partial enlarged view of area I in FIG. 18.
FIG. 20 is a perspective schematic structural view of a locking device according to at least one embodiment of the disclosure.
FIG. 21 is an exploded view of the locking device according to at least one embodiment of the disclosure.
FIG. 22 is another perspective schematic structural view of the backpack blower according to at least one embodiment of the disclosure.
FIG. 23 is a cross-sectional view of a tail part of air duct of the backpack blower according to at least one embodiment of the disclosure.
FIG. 24 is a partial enlarged view of area V in FIG. 23.
FIG. 25 is a partial enlarged view of area II in FIG. 24.
FIG. 26 is a schematic view of the air duct of a cooling structure of an electric component according to at least one embodiment of the disclosure.
FIG. 27 is an internal schematic structural view of a cover casing according to at least one embodiment of the disclosure.
FIG. 28 is a partial enlarged view of area III in FIG. 27.
FIG. 29 is an internal schematic structural view of the cover casing from another angle according to at least one embodiment of the disclosure.
FIG. 30 is a partial enlarged view of area IV in FIG. 29.

### DETAILED DESCRIPTION

The following describes the implementation of the disclosure through specific embodiments, and those skilled in the art can easily understand other advantages and effects of the disclosure from the content disclosed in this specification. The disclosure may also be implemented or applied through other different specific embodiments. Various details in this specification may also be modified or changed based on different viewpoints and applications without departing from the disclosure. It should be noted that, the following embodiments and the features in the embodiments can be combined with each other without conflict.

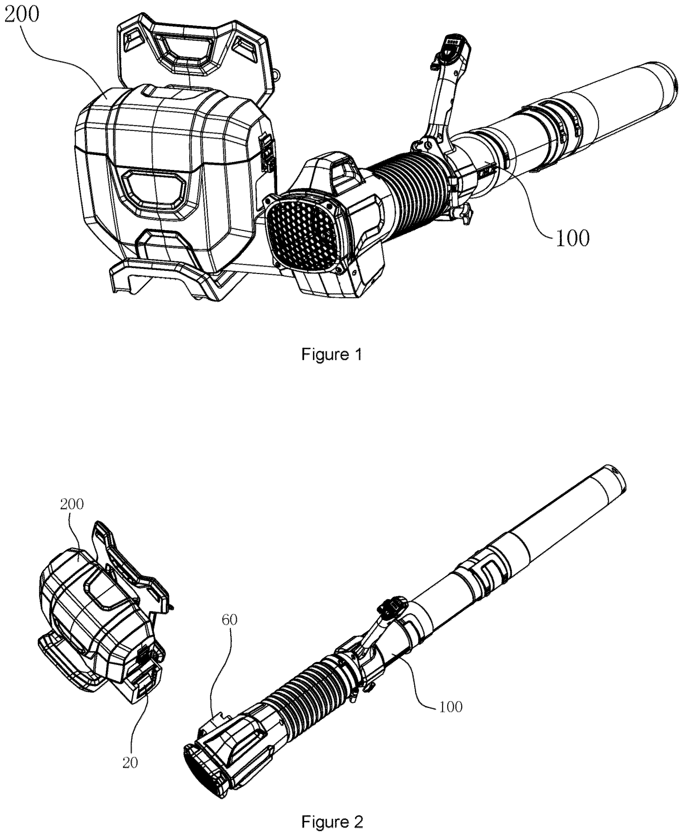

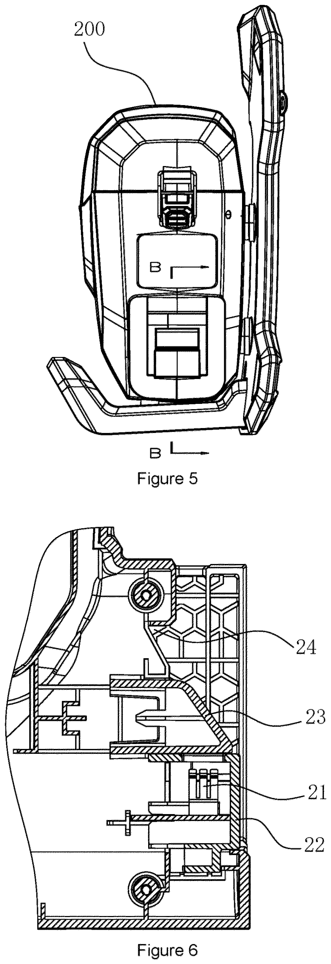

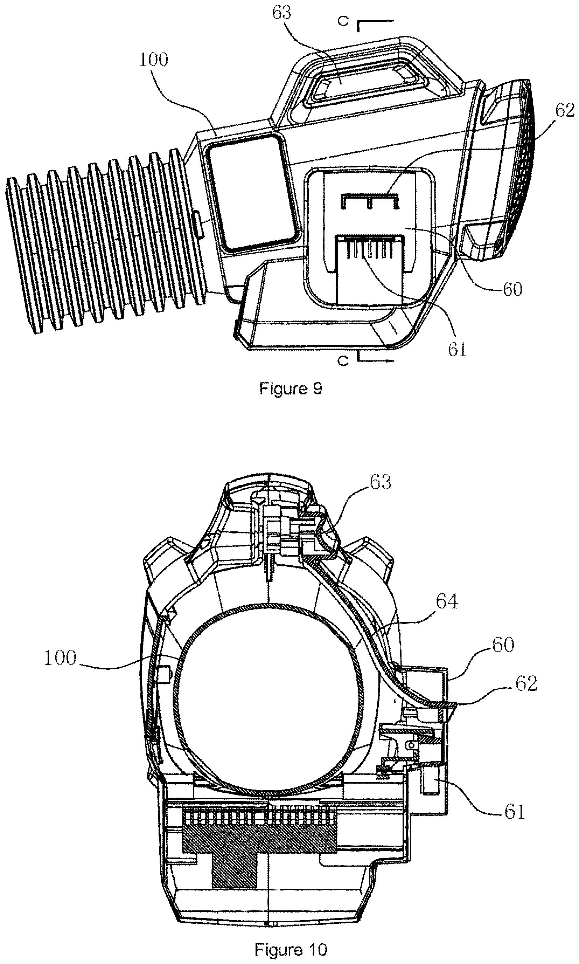

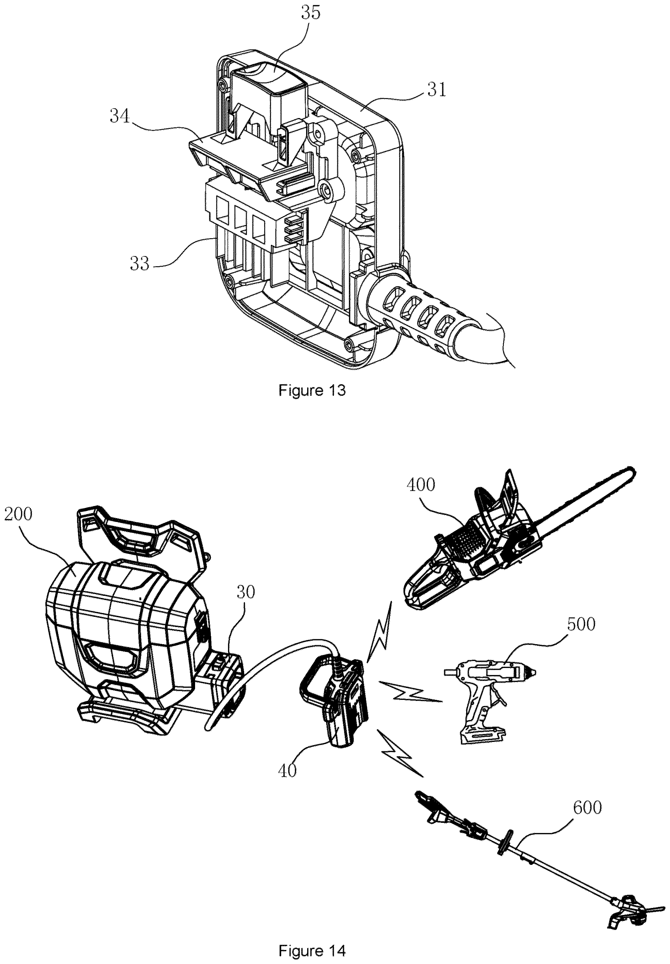

Please refer to FIG. 1 through FIG. 14. The following is combined with a backpack blower to describe a technical scheme of the disclosure in detail. It may be understood that the disclosure extends a function of conventional garden tools, and utilizes a battery pack of the conventional garden tool to supply power to other garden tools. Please refer to FIG. 14. Other garden tools mentioned here may be for example a string trimmer 600, a chainsaw 400, a hedge trimmer, a hand-held blower or a power tool 500, etc. A backpack battery pack, the garden tool and a coupling device in the disclosure may all be used as an independent product, and of course may also be used as a complete set of products, such as an extendable backpack blower with a coupling module, or an extendable hedge trimmer with the coupling module, or an extendable string trimmer with the coupling module.

Please refer to FIG. 1 through FIG. 10. The disclosure provides the backpack blower, the backpack blower includes a backpack battery pack 200 and an air duct 100. The air duct 100 is detachably connected with the backpack battery pack. It may be understood that, the blower may use a flexible tube to adjust a direction of an air outlet, so compared with other garden tools such as hedge trimmers and string trimmer, a main body part of the blower has lower freedom of movement requirements, and may be directly connected with the backpack battery pack 200. The blower is mounted directly on the backpack battery pack 200, which also helps to reduce a burden on arms of a worker. And for garden tools such as hedge trimmers, string trimmer, it is necessary to ensure that there is a considerable degree of freedom of movement between a main body and the backpack battery pack 200, so the disclosure is provided with a detachable coupling device for the backpack battery pack 200 to adapt to these devices.

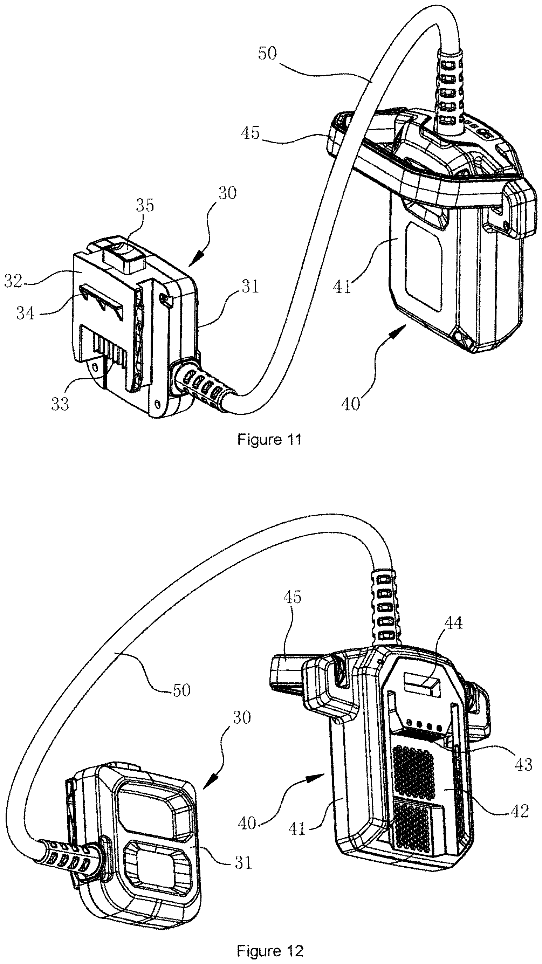

Please refer to FIG. 11 through FIG. 13. The coupling device includes a first coupling unit 30 and a second coupling unit 40. The first coupling unit 30 is detachably connectable with a power supply output end of the backpack battery pack 200. The second coupling unit 40 is connected with the first coupling unit 30 through a flexible wire 50, and the second coupling unit 40 is configured to be detachably connectable with a power input end of a first garden tool such as the hedge trimmer or the string trimmer. It may be understood that, a detachable connection of the disclosure not only refers to a connection of a structural level, but also includes a connection of a circuit part.

The disclosure realizes a functional expansion of a backpack blower through the coupling device. When need to use the blower, the blower may be directly connected with the backpack battery pack 200. When need to use other garden tools such as the hedge trimmer or the string trimmer, the blower is removed from the backpack battery pack 200, and then the coupling device of the disclosure is utilized to connect the garden tools with the backpack battery pack 200, which may realize a power supply of these garden tools. The disclosure reduces cost of garden tools and devices.

Please refer to FIG. 2 through FIG. 10. In an embodiment, a first inserting groove 20 is arranged on the backpack battery pack 200, and a second plug-in part matched with the first inserting groove 20 is arranged on the air duct 100. One end of the second plug-in part is provided with a fourth terminal 61. The fourth terminal 61 is configured so that when the second plug-in part is inserted and matched with the first inserting groove 20, the fourth terminal 61 can contact with a second terminal 21 arranged in the first inserting groove 20. In an embodiment, the second plug-in part includes a second protruding part 60 formed on a housing of the air duct 100, and a second limiting groove is formed on two sides of the second protruding part 60. It may be understood that, a structure of the first inserting groove 20 and the second plug-in part is not limited to a scheme provided in the embodiment. For example, the first inserting groove 20 and the second plug-in part may also be round holes and cylindrical structures that are matched with each other, or other structures with equivalent functions obtained by simple changes on a basis of the embodiment.

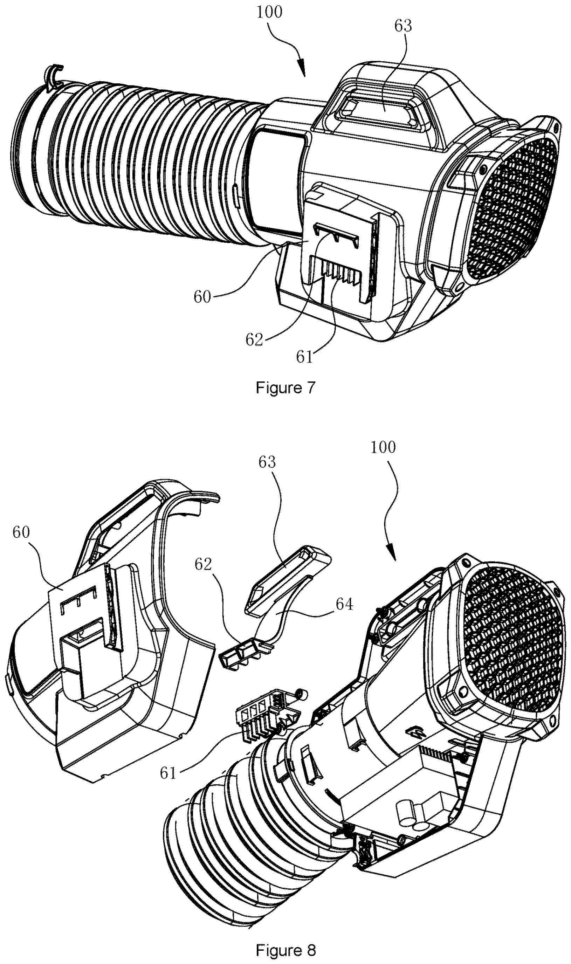

Please refer to FIG. 7 through FIG . 10. In a further embodiment, the second plug-in part includes a second deadbolt 62 matched with a first clamping groove 24 arranged in the first inserting groove 20. The second deadbolt 62 is movably connected with the housing of the air duct 100, and a moving direction is perpendicular to an inserting direction of the second plug-in part and the first inserting groove 20, so that the second deadbolt 62 can switch between following two states. In a first state, the second deadbolt 62 protrudes from a surface of the second plug-in part. And in a second state, the second deadbolt 62 shrinks into an inside of the second plug-in part. The second deadbolt 62 is connected with a pressing handle 63 through a connecting plate 64, and a second elastic unit (not shown) is arranged between the pressing handle 63 and the housing of the air duct 100. It may be understood that, when the second plug-in part is inserted and matched with the first inserting groove 20, the second deadbolt 62 can be ejected into the first clamping groove 24, and then prevent the second plug-in part from being separated from the first inserting groove 20. When the worker squeezes the pressing handle 63, the second deadbolt 62 can be withdrawn from the first clamping groove 24, and then the second plug-in part can be smoothly pulled out from the first inserting groove 20.

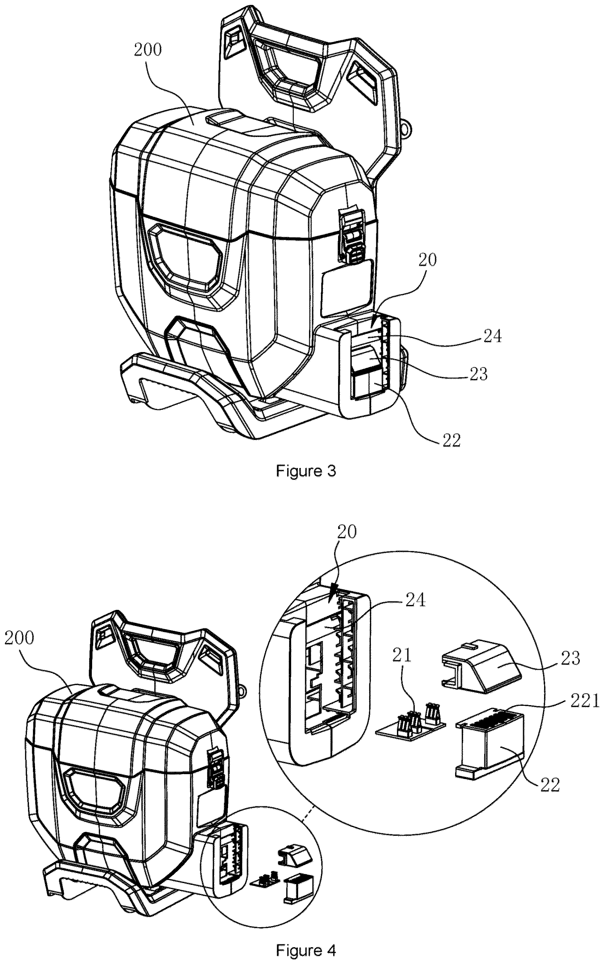

Please refer to FIG. 3 through FIG. 6. In an embodiment, a cover casing 22 is mounted on the second terminal 21, and an inserting hole 221 is opened and arranged on the cover casing 22. The first inserting groove 20 is further provided with a protective block 23, and the protective block 23 is movably connected with the first inserting groove 20 so that the protective block 23 can be switched between the following two stations. In a station a, the protective block 23 is blocked on an outside of the inserting hole 221, and in a station b, the protective block 23 is removed from the outside of the inserting hole 221 to expose the inserting hole 221. In an embodiment, a moving direction of the protective block 23 is perpendicular to an inserting direction of the second plug-in part and the first inserting groove 20. The protective block 23 is provided with an inclined wedge surface. When the second plug-in part is inserted and matched with the first inserting groove 20, the second plug-in part can drive the protective block 23 at the station a to be switched to the station b through the inclined wedge surface. A third elastic unit (not shown in the figure) is arranged between the protective block 23 and a housing of the backpack battery pack 200, and the third elastic unit is configured to be capable of driving the protective block 23 at the station b to be switched to the station a with its elastic force. It may be understood that, the protective block 23 can provide a protection for the second terminal 21 when the first inserting groove 20 is not connected with any garden tool, and has certain waterproof, dust-proof functions.

Please refer to FIG. 11 through FIG. 13. In an embodiment, the first coupling unit 30 includes a first housing 31, the first housing is provided with a first plug-in part, the first plug-in part is matched with the first inserting groove 20 arranged on the backpack battery pack 200, an end of the first plug-in part is provided with a first terminal 33, and the first terminal 33 is configured so that when the first plug-in part is inserted into the first inserting groove 20, the first terminal 33 is capable of contacting with a second terminal 21 arranged in the first inserting groove 20. It may be understood that, in this embodiment, the first coupling unit 30 and the blower may be connected to a same inserting groove of the backpack battery pack 200.

Please refer to FIG. 11 through FIG. 13. In an embodiment, the first plug-in part includes a first protruding part 32 formed on one end face of the first housing 31, and a first limiting groove is formed at two sides of the first protruding part 32. The first coupling unit 30 further includes a first deadbolt 34 matched with the first clamping groove 24 arranged in the first inserting groove 20, the first deadbolt 34 is movably connected with the first housing 31, a moving direction of the first deadbolt 34 is perpendicular to an inserting direction of the first plug-in part and the first inserting groove 20, the first deadbolt 34 is configured to be capable of switching between following two stations, in a station one, the first deadbolt 34 protrudes from a surface of the first housing 31, and in a station two, the first deadbolt 34 shrinks into an inside of the first housing 31.

Please refer to FIG. 11 through FIG. 13. Further, a first elastic unit (not labeled) is arranged between the first deadbolt 34 and the first housing 31, the first elastic unit is configured such that its elastic force is capable of driving the first deadbolt 34 at the station two to be switched to the station one, the first housing 31 is provided with an unlocking button 35, the unlocking button 35 is in a transmission connection with the first deadbolt 34, and the unlocking button 35 is configured so that when the unlocking button 35 is pressed by an external force, the first deadbolt 34 at the station one can be driven to be switched to the station two.

It may be understood that, in this embodiment, the first coupling unit 30 and the blower have a same specification of plug-in part, its difference is only that an unlocking mode of the deadbolt is slightly different. For example, a matching wedge block may be arranged between the unlocking button 35 and the first deadbolt 34 of the first coupling unit 30 to transmit a vertical movement, and the blower is be provided with the pressing handle 63 at a tail part of the air duct 100 to drive the second deadbolt 62 to move. Both need a spring to reset, and the springs preferably use compression springs.

Please refer to FIG. 11 through FIG. 13. In an embodiment, the second coupling unit 40 includes a second housing 41, a second receiving part 42 is formed on the second housing 41, and a third terminal 43 is arranged in the second receiving part 42. The second housing 41 is provided with a movable handle 45, and the movable handle 45 is rotatably connected with the second housing 41. It may be understood that, the second receiving part 42 is used for adapting the hedge trimmers, the string trimmers and other garden tools. Correspondingly, these garden tools should be provided with a plug part that is matched with the second receiving part 42. A second clamping groove 44 is arranged on the second coupling unit 40, and other garden tools such as the hedge trimmers, the string trimmers should be provided with the deadbolt that is suitable for the second clamping groove 44, so that when the second coupling unit 40 is connected with these garden tools, the plug is prevented from being separated from the second clamping groove 44. An arrangement of the deadbolt may refer to an arrangement of the second deadlock 62 in the above embodiment, which is not repeated herein.

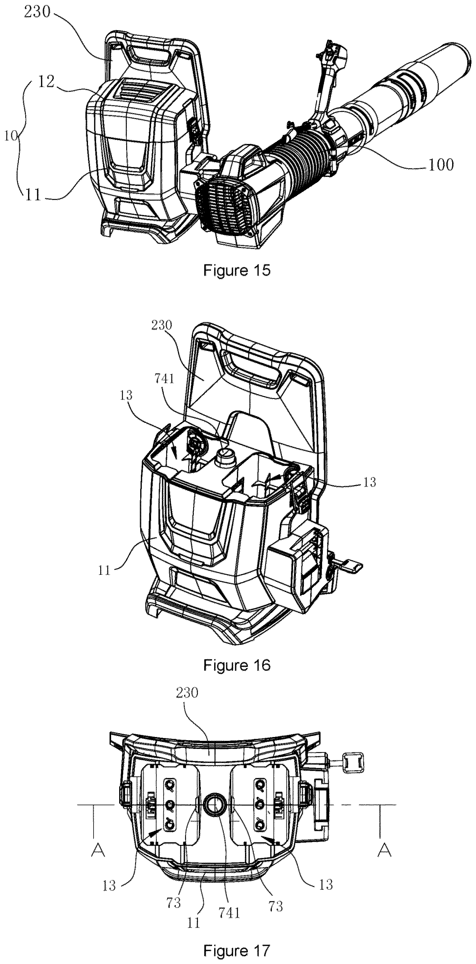

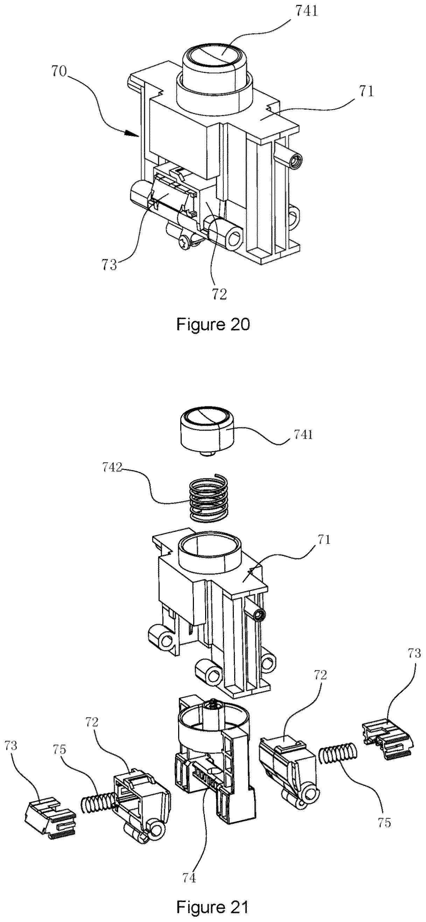

Please refer to FIG. 15 through FIG. 21. The backpack battery pack 200 includes a backpack base 230, a battery pack compartment 10 and a battery pack.

Please refer to FIG. 15. The air duct 100 is mounted on a side part of the backpack base 230, the battery pack compartment 10 is fixed on the backpack base 230, and the battery pack is mounted inside the battery pack compartment 10. It may be understood that, necessary power connection components are arranged between the air duct 100 and the battery pack compartment 10.

Please refer to FIG. 15 and FIG. 16. In an embodiment of the disclosure, a detachable structure may be arranged between the air duct 100 and the backpack base 230. It may be understood that, the backpack base 230 and the battery pack compartment 10 are named based on a functional distinction. In an embodiment, the backpack base 230 and the battery pack compartment 10, for example, may be an integrated structure, and of course the two may also be separating structures.

Please refer to FIG. 15 through FIG. 21. The battery pack compartment 10 includes a casing 11 and a locking device 70.

Please refer to FIG. 15 through FIG. 18. The casing 11 encloses a cavity 13 with an upper end open. In this embodiment, the casing 11 encloses two cavities 13, which indicates that the battery pack compartment 10 can carry two battery packs at the same time. In an embodiment, the casing 11, for example, may be assembled by a plurality of injection molded components, necessary supporting and limiting components are arranged in the cavity 13, and these supporting and limiting components may, for example, be integrated with the casing 11 itself for injection molding.

Please refer to FIG. 15. Further, in order to realize a waterproof function of the battery pack compartment 10, a compartment cover 12 may be correspondingly arranged above the casing 11, and a quick-release buckle is arranged between the compartment cover 12 and the casing 11.

Please refer to FIG. 17 through FIG. 21. The locking device 70 includes a base 71, a movable part 72, a deadbolt 73, a first holding mechanism and a second holding mechanism.

Please refer to FIG. 17 through FIG. 21. The base 71 is fixed in the casing 11, in an embodiment, the base 71 is fixed in an interlayer between the two cavities13. It may be understood that, a position of the base 71 may be adaptively adjusted according to a position distribution of the cavities 13, so that the locking device 70 can control as many battery packs as possible. The base 71 and the casing 11 may, for example, be an integral structure or a separating structure.

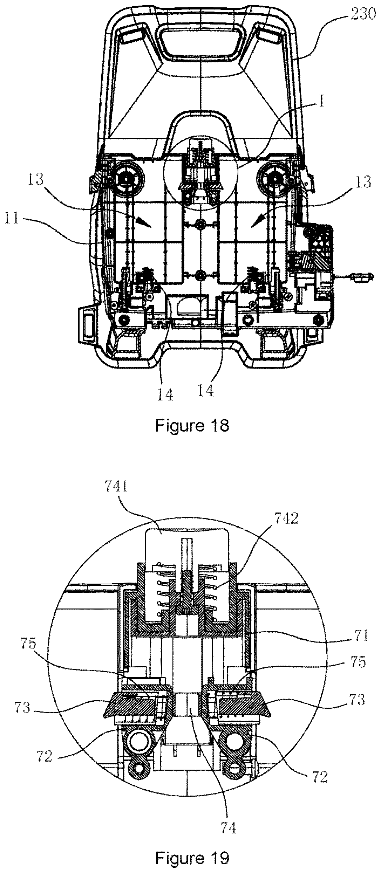

Please refer to FIG. 19 through FIG. 21. The movable part 72 is movably connected with the base 71 and is provided with a first position and a second position relative to the base 71. In this embodiment, the movable part 72 is hinged with the base 71, and the movable part 72 is switched between the first position and the second position by swinging.

Please refer to FIG. 19 through FIG. 21. The deadbolt 73 is movably connected with the movable part 72 and provided with a first station and a second station relative to the movable part 72. In this embodiment, the deadbolt 73 is slidably connected with the movable part 72.

Please refer to FIG. 19 through FIG. 21. The first holding mechanism is arranged between the base 71 and the movable part 72, and the first holding mechanism is configured to be capable of holding the movable part 72 in the first position and releasing the movable portion 72 from the first position. Based on a connection mode of the movable part 72 with the base 71 in this embodiment, the first holding mechanism includes a blocking part 74 slidably connected with the base 71, the blocking part 74 is provided with a holding station and a releasing station along a sliding direction. When the blocking part 74 is at the holding station, the blocking part 74 blocks the movable part 72 at the first position to limit it at the first position. When the blocking part 74 is at the releasing station, the blocking part 74 leaves a swinging path of the movable part 72, so that the movable part 72 is capable of swinging to the second position.

An advantage of the above embodiment is that after the blocking part 74 is switched from the holding station to the releasing station, the movable part 72 can be automatically moved to the second position during a lifting process of the battery pack, so there is no need to carry out redundant driving operation to the movable part 72.

It may be understood that, in addition to the above embodiment, the movable part 72 may also be slidably connected with the base 71. Correspondingly, the first holding mechanism needs to make corresponding changes. For example, when the first holding mechanism switches from the holding station to the releasing station, the movable part 72 needs to be driven to be switched from the first position to the second position, so that the battery pack can be smoothly taken out. For example, this function may be realized through a spring.

Please refer to FIG. 19 through FIG. 21. The second holding mechanism is arranged between the deadbolt 73 and the movable part 72. In this embodiment, the second holding mechanism is a second elastic unit 75 arranged between the deadbolt 73 and the movable part 72.

Please refer to FIG. 19. When the movable part 72 is in the first position and the deadbolt 73 is at the first station, an end part of the deadbolt 73 protrudes into the cavity 13 from the side wall of the cavity 13, and when the movable part 72 and deadbolt 73 are in combinations of remaining positions and stations, the end part of the deadbolt 73 leaves the cavity. It may be understood that, the remaining positions and stations includes that the movable part 72 is at the second station and the deadbolt 73 is at the first station, or the movable part 72 is at the second station and the deadbolt 73 is at the second station, or the movable part 72 is at the first station and the deadbolt 73 is at the second station.

The second holding mechanism is configured to be capable of holding the deadbolt 73 at the first station, and when the deadbolt 73 protrudes into the cavity 13 and the end part of the deadbolt 73 is subjected to an external force that is vertically downward, the deadbolt 73 is capable of overcoming constraints of the second holding mechanism to be switched to the second station.

It may be understood that, the battery pack should be provided with a necessary locking groove. When the battery pack is inserted into the cavity 13, a bottom of the battery pack can push the deadbolt 73 away from the cavity 13. When the locking groove is directly opposite the deadbolt 73, the deadbolt 73 can be ejected into the locking groove under an effect of the second elastic unit 75, so that the battery pack can be fixed.

Please refer to FIG. 19. A first elastic unit 742 is arranged between the blocking part 74 and the base 71, a releasing button 741 is attached to the blocking part 74, and an upper side of the end part of the deadbolt 73 is provided with an inclined plane.

Please refer to FIG. 18 and FIG. 19. In an embodiment of the disclosure, a bottom of the cavity 13 is provided with a third elastic unit 14. The locking device 70 is respectively provided with the deadbolt 73, the movable part 72 and the second holding mechanism corresponding to each cavity 13, and each of the deadbolt 73, the movable part 72 and the second holding mechanism share the same base 71 and the first holding mechanism.

Based on the above embodiments, a specific operation process and principle of the disclosure are as follows.

A mounting process of the battery pack includes that, first, the compartment cover 12 is opened. Then the battery pack is directly inserted into the cavity 13 according to a preset direction, a bottom surface of the battery pack can push the deadbolt 73 away from the cavity 13 at this moment, so the deadbolt 73 will not cause obstruction to a downward movement of the battery pack. When the battery pack falls to the bottom of the cavity 13, a certain downward pressure needs to be applied to the battery pack, so that it can overcome an elastic force of the third elastic unit 14 until the locking groove on the battery pack is directly opposite the deadbolt 73. Then the deadbolt 73 can be ejected into the locking groove to prevent the battery pack from going up, finally the compartment cover 12 is closed, and a mounting of the battery pack is completed. The battery pack is always pressed by the third elastic unit 14 in the cavity 13, which can effectively avoid a vibration of the battery pack caused by an assembly gap.

**A** battery pack disassembly process includes that first, the compartment cover 12 is opened, then the releasing button 741 is pressed, at this moment the movable part 72 loses a limitation of the blocking part 74, and because of the third elastic unit 14, the deadbolt 73 is again subjected to a bottom-up thrust from the battery pack, so that the movable part 72 can swing in a direction away from the cavity 13 under a squeezing and pushing effect of the battery pack, then the deadbolt 73 leaves the cavity 13, the battery pack ejects a distance from the cavity 13 under an effect of the third elastic unit 14 at this moment, an operator then withdraws the battery pack from the cavity 13, and the battery pack is disassembled completely.

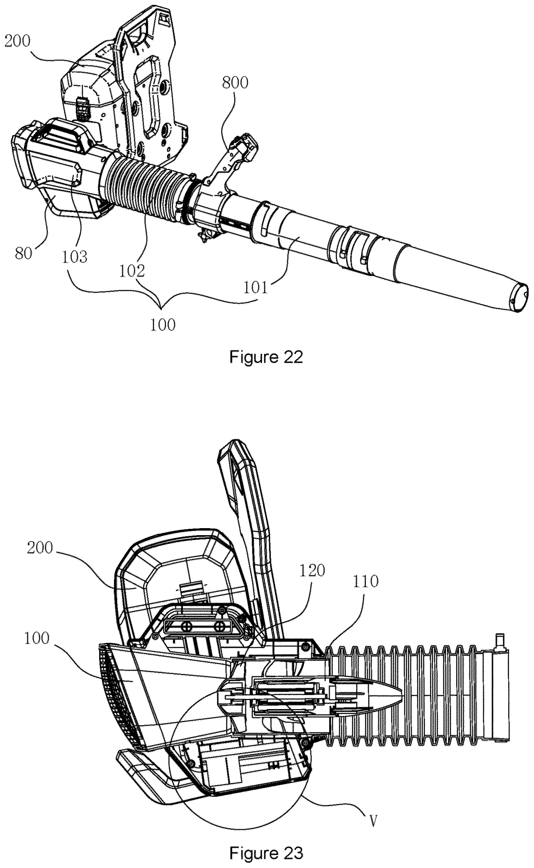

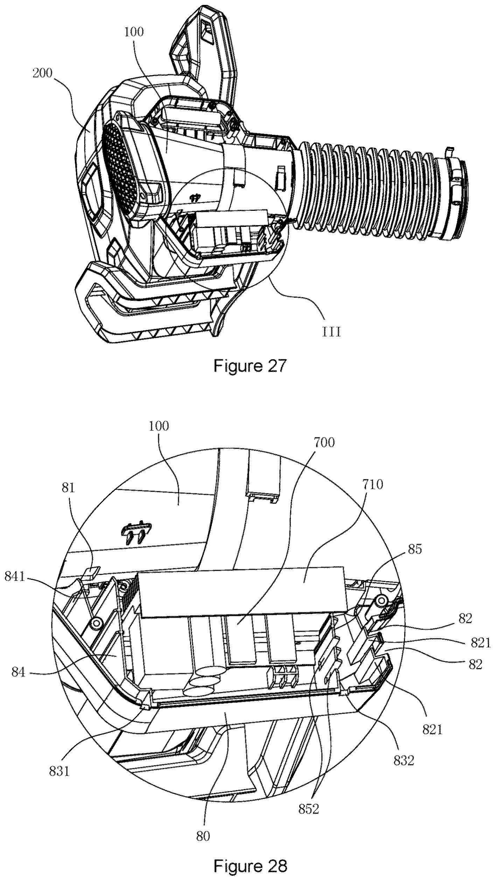

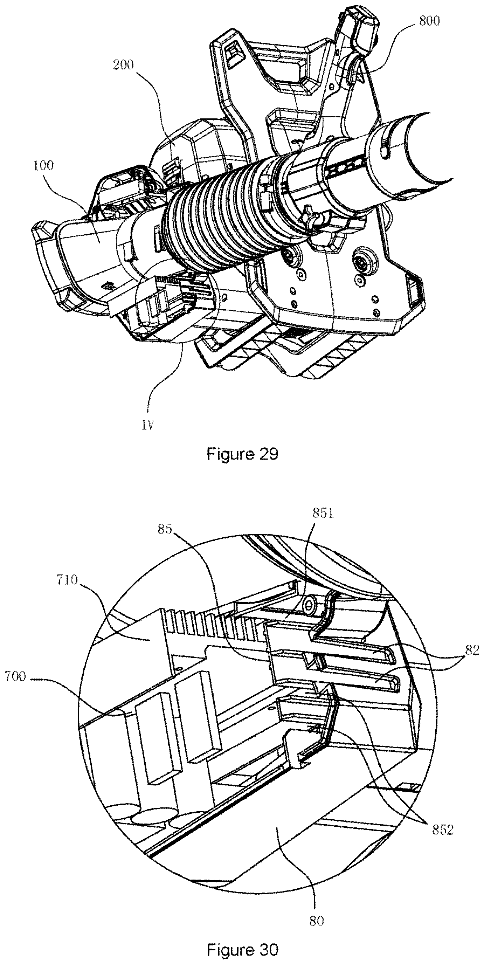

Please refer to FIG. 22 through FIG. 30. The blower further includes an impeller 120, a driving module and a control module.

The driving module is the motor 110, and the control module is the electric component 700. The impeller 120 is rotably arranged in the air duct 100. The driving module is mounted in the air duct 100 and is connected with the impeller 120. The backpack battery pack 200 is connected with the driving module. The control module and the driving module are connected with the backpack battery pack 200. The control module is mounted in the cover casing 80, and the cover casing 80 is provided with a first vent 81 and a second vent 82. The first vent 81 communicates the inner cavity of the cover casing 80 with the air duct 100. The second vent 82 communicates the inner cavity of the cover casing 80 with the air.

Please refer to FIG. 22 through FIG. 30. The cover casing 80 is used to mount the electric component 700. The cover casing 80, for example, may be an injection molded component. It may be understood that, the electronic component 700 is generally welded on a circuit board, and a limiting member for mounting the circuit board is correspondingly arranged in the cover casing 80, and the limiting member may be a clamping groove, a buckle or a screw hole and the like for example.

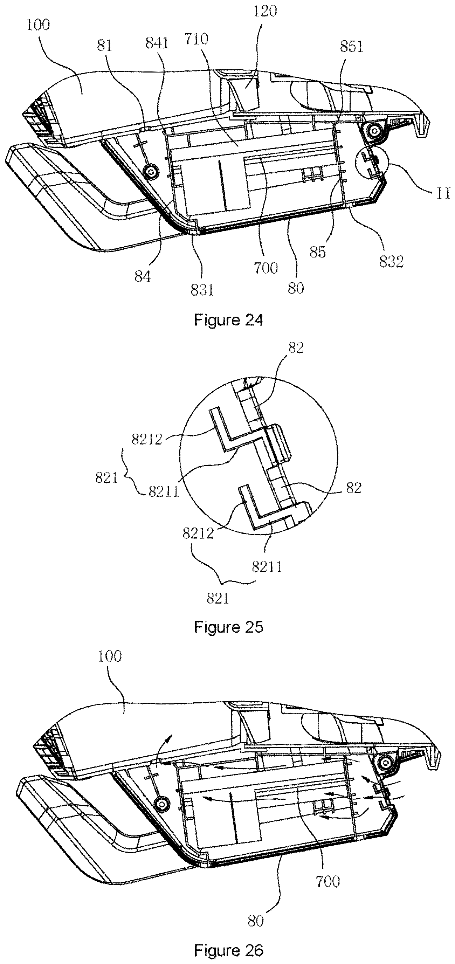

Please refer to FIG. 24 through FIG. 28. The first vent 81 communicates the inner cavity of the cover casing 80 with the air duct 100 of the blower. It may be understood that, the first vent 81 of the disclosure is a functional structure, and it is sufficient as long as the inner cavity of the cover casing 80 can be communicated with the air duct 100 of the blower, while an actual structural form of the first vent 81 has no special requirements. For example, the first vent 81 may be a section of tube with a solid structure, or it may be a common space between the inner cavity of the cover casing 80 and the air duct 100, or it may be a hole or a gap in a common wall shared by the cover casing 80 and the air duct 100.

Please refer to FIG. 24 through FIG. 30. The second vent 82 communicates the inner cavity of the cover casing 80 with the air. It may be understood that, the second vent 82 of the disclosure is also the functional structure, and it is sufficient as long as the inner cavity of the cover casing 80 can be communicated with the air, while an actual structural form of the first vent 82 has no special requirements. For example, the first vent 82 may be the section of tube with the solid structure, or it may also be a hole or a gap opened on a wall of the cover casing 80 or a mesh grille arranged on the cover casing 80.

Please refer to FIG. 24 through FIG. 28. In an embodiment of the disclosure, the first vent 81 is communicated with an air inlet of the air duct 100. In this embodiment, the air duct 100 includes a hand-held section 101, an air inlet section 103 and a corrugated section 102. The hand-held section 101 is located at a front end of the air duct 100, the air inlet section 103 is located at a rear end of the air duct 100, the corrugated section 102 is located between the hand-held section 101 and the air inlet section 103, and the corrugated section 102 is a flexible tube. The air inlet section 103 is provided with the motor 110 and the impeller 120, and the hand-held section 101 is provided with an operating handle 800. In this embodiment, the first vent 81 communicates with an air inlet of the impeller 120. When impeller 120 works, the air inlet can generate a certain negative pressure, correspondingly enables the inner cavity of the cover casing 80 to generate the negative pressure, so the air can enter the cover casing 80 from the second vent 82 and merge with air flow of the air duct 100 from the first vent 81, heat generated by the electronic component 700 can be taken away when the air flow passes through the inner cavity of the cover casing 80, and then play an effect of cooling.

It is foreseeable that, in addition to the above embodiments, the first vent 81 of the disclosure may also be communicated with an air outlet of the impeller 120, and at this moment, the air flow will flow into the cover casing 80 from the first vent 81 and flow out from the second vent 82.

Please refer to FIG. 22 through FIG. 30. In an embodiment of the disclosure, the cover casing 80 is mounted on an outer wall of the air duct 100 and has a common wall between the air duct 100, and the first vent 81 is formed on the common wall. Further, the cover casing 80 is a two-half structure, and the cover casing 80 is clamped outside the air duct 100 and is fixed through the screw.

Please refer to FIG. 24 and FIG. 26. The second vent 82 and the first vent 81 are respectively arranged at two remote ends of the cover casing 80, and the electronic components 700 are mounted on a cooling air duct formed between the second vent 82 and the first vent 81. In an embodiment, the first vent 81 is arranged close to a rear end of the common wall, and the second vent 82 is located on a front side of the cover casing 80. The "front" and "rear" of the disclosure are based on an air flow direction in the air duct of the blower, which means that the air outlet is the front side, and the air inlet is the rear side. It may be understood that, the two remote ends of the cover casing 80 do not specifically refer to two specific positions, but refer to at least a sufficiently long cooling air duct that can be formed between the first vent 81 and the second vent 82, so that the air flow can carry out a full heat exchange with the electronic component 700 after entering the cover casing 80. Please refer to FIG. 26. The first vent 81 in the figure is located at an upper left end of a mounting area of the electronic component 700, and the second vent 82 is located at a lower right end of the mounting area of the electronic component 700. It is foreseeable that, as an extension of the embodiment, the first vent 81 and the second vent 82 may also be arranged at left and right ends or upper and lower ends of the mounting area of the electronic component 700.

Please refer to FIG. 22 through FIG. 30. The cover casing 80 is located at a lower side of the air duct 100, and a bottom of the cover casing 80 is provided with a drainage port. It is foreseeable that, in a rainy day environment, when a fan machine sucks air, there must be a part of rainwater that is sucked into the air duct 100, and the rainwater can flow into the cover casing 80 from the first vent 81. In addition, the cover casing 80 itself may also seep into the rainwater because of a poor sealing. Because of this problem, the disclosure arranges the cover casing 80 below the air duct 100, so that the cover casing 80 can be convenient to drain from the bottom, and the rainwater is prevented from being in contact with the electronic component 700 and causing a short circuit or corrosion.

Please refer to FIG. 24 through FIG. 30. The drain port includes a first drainage port 831 arranged below the first vent 81. A first water baffle 84 is arranged in the cover casing 80, the first vent 81 and the first drainage port 831 are located on a same side of the first water baffle 84. The electronic component 700 is mounted on the other side of the first water baffle 84, and an upper end of the first water baffle 84 is provided with a first air hole 841. In an embodiment of the disclosure, the first water baffle 84, for example, may be integrally injection molded with the cover casing 80, and the first water baffle 84 isolates spaces where the first vent 81 and the first drainage port 831 are located from a space where the electronic component 700 is located. The first air vent 841 for communicating the first vent 81 and the electric component 700 is only arranged at a top of the first water baffle 84. The rainwater can be directly discharged from the first drainage port 831 after entering the cover casing 80 from the first vent 81, and does not accumulate in the cover casing 80, and a rainwater flow path can avoid the electronic component 700 and prevent the electronic component 700 from being short-circuited or corroded, etc.

Please refer to FIG. 24 through FIG. 30. The drain port further includes a second drainage port 832 arranged close to the second vent 82. A second water baffle 851 is arranged in the cover casing 80, the second vent 82 and the second drainage port 832 are located on a same side of the second water baffle 851. The electronic component 700 is mounted on the other side of the second water baffle 851, and an upper end of the second water baffle 851 is provided with a second air hole 851. It may be understood that, in the rainy day environment, there is also likely part of the rainwater in the air sucked from the second vent 82. The disclosure is provided with a same drainage structure on this side, which means the second water baffle 851 and the second drainage port 832. The upper end of the second water baffle 851 is provided with the second air hole 851, an air flow passage is formed between the second air hole 851 and the first air hole 841, and this air flow passage passes through a top of the electronic component 700 and can take away most of the heat.

Please refer to FIG. 24 through FIG. 30. In an embodiment of the disclosure, the cover casing 80 is provided with a heat dissipation block 710. The electronic component 700 is mounted at a lower end of the heat dissipation block 710, the first air hole 841 and the second air hole 851 are located above two ends of the heat dissipation block 710. In an embodiment, the heat dissipation block 710 is an aluminum heat dissipation block 710. A bottom surface of the heat dissipation block 710 is a plane and is attached with circuit board, or thermal conductive adhesive may be arranged between the heat dissipation block 710 and the circuit board. An upper end of heat dissipation block 710 is provided with fins to improve heat exchange efficiency with the air.

Please refer to FIG. 24, FIG. 28 and FIG. 30. A middle part of the first water baffle 84 and/or the second water baffle 851 is provided with a wiring hole 852. It may be understood that part of the air flow can pass through the wiring hole 852 to dissipate heat for the electronic component 700 from below the circuit board.

Please refer to FIG. 25, FIG. 28 and FIG. 30. In a further embodiment of the disclosure, the second vent 82 is provided with a water blocking platform 821. The water blocking platform 821 includes a first extending part 8211 extending from a lower edge of the second vent 82 to the cover casing 80, and a second extending part 8212 extending upwards from an inner end of the first extending part 8211, and the water blocking platform 821 may be integrated with the cover casing 80 for injection molding. The water blocking platform 821 can block most of the rainwater from entering the cover casing 80 from the second vent, which reduces an internal drainage burden of the cover casing 80.

In summary, the disclosure realizes a functional expansion of a backpack blower through the coupling device. When need to use the blower, the blower may be directly connected with the backpack battery pack 200. When need to use other garden tools such as the hedge trimmer or the string trimmer, the blower is removed from the backpack battery pack 200, and then the coupling device of the disclosure is utilized to connect the garden tools with the backpack battery pack 200, which may realize a power supply of these garden tools. The disclosure reduces cost of garden tools and devices.

The disclosure has realized a rapid mounting and disassembly of the battery pack through a cooperative matching of the movable part 72 and the deadbolt 73, which improves battery replacement efficiency of the garden tools, and then improves work efficiency. In addition, a plurality of battery packs of the disclosure shares one locking device 70, which realizes a one-key release of the plurality of battery packs, further improves the battery replacement efficiency, and reduces labor intensity. The disclosure utilizes an insertion and ejection action of the battery pack itself to realize a switching between different states of the locking device 70, and simplifies a device structure and operation process.

The disclosure communicates a position where the electronic component 700 is located with the air duct 100 of the blower. When the blower works, air flow can be generated around the electronic component 700, and then take away heat generated by the electronic component 700, which has a cooling effect, and improves the duration life of the blower. In addition, the disclosure is provided with the water baffle and the drainage port in the cover casing 80, which can prevent the electronic component 700 from being short-circuited or corroded when the blower is operating in the rainy day.

The above embodiments only illustrate principles and effects of the disclosure, but are not intended to limit the disclosure. Anyone familiar with this technology may modify or change the above embodiments without departing from a scope of the disclosure. Therefore, all equivalent modifications or changes made by those with ordinary knowledge in the technical field without departing from the technical ideas disclosed in the disclosure shall still be covered by the claims of the disclosure.

## Claims

1. A coupling device, comprising:
a first coupling unit, configured to be detachably connectable with a power supply output end of a backpack battery pack; and
a second coupling unit, connected with the first coupling unit through a flexible wire, and configured to be detachably connectable with a power input end of a first garden tool.

2. The coupling device according to claim 1, wherein, the first coupling unit comprises a first housing, the first housing is provided with a first plug-in part, the first plug-in part is matched with a first receiving part arranged on the backpack battery pack, the first plug-in part is provided with a first terminal, and the first terminal is configured to be capable of contacting with a second terminal arranged in the first receiving part when the first plug-in part is inserted into the first receiving part.

3. The coupling device according to claim 2, wherein, one of the first plug-in part and the first receiving part is provided with a first protruding part, the other one of the first plug-in part and the first receiving part is provided with a first inserting groove, and when the first protruding part is inserted into the first inserting groove, the first terminal is electrically connected with the second terminal.

4. The coupling device according to claim 3, wherein, the first protruding part is provided with a first deadbolt matched with a first clamping groove arranged in the first inserting groove, the first deadbolt is movably connected with the first protruding part, a moving direction of the first deadbolt is perpendicular to an inserting direction of the first plug-in part and the first receiving part, the first deadbolt is configured to be switchable between two stations, in a station one, the first deadbolt protrudes from a surface of the first protruding part, and in a station two, the first deadbolt shrinks into an inside of the first protruding part.

5. The coupling device according to claim 4, wherein, a first elastic unit is arranged between the first deadbolt and the first housing, the first elastic unit is configured such that an elastic force thereof is capable of driving the first deadbolt at the station two to be switched to the station one, the first housing is provided with an unlocking button, the unlocking button is in a transmission connection with the first deadbolt, and the unlocking button is configured to drive the first deadbolt at the station one to be switched to the station two when the unlocking button is pressed by an external force.

6. The coupling device according to claim 1, wherein, the second coupling unit comprises a second housing, the second housing is provided with a second receiving part, and a third terminal is arranged in the second receiving part.

7. A backpack garden tool system, comprising:
a backpack battery pack;
a second garden tool, detachably connectable with a power supply output end of the backpack battery pack; and
a coupling device, comprising:
a first coupling unit, replaceable with the second garden tool and detachably connectable with the power supply output end of the backpack battery pack, and
a second coupling unit, connected with the first coupling unit through a flexible wire, and configured to be detachably connectable with a power input end of a first garden tool.

8. The backpack garden tool system according to claim 7, wherein, the backpack battery pack comprises:
a backpack base;
a battery pack compartment, arranged on the backpack base and provided with a cavity to accommodate a battery pack, and
a locking device, mounted on a side wall of the cavity, and configured to lock the battery pack in the cavity and release a lock of the battery pack so as to withdraw the battery pack from the cavity.

9. The backpack garden tool system according to claim 8, wherein, the locking device comprises:
a base, fixed in the battery pack compartment;
a movable part, movably connected with the base and movable relative to the base between a first position and a second position;
a deadbolt, movably connected with the movable part and movable relative to the movable part between a first station and a second station;
a first holding mechanism, arranged between the base and the movable part, and configured to be capable of holding the movable part in the first position and releasing the movable portion from the first position; and
a second holding mechanism, arranged between the deadbolt and the movable part; wherein
when the movable part is in the first position and the deadbolt is at the first station, an end of the deadbolt protrudes into the cavity from the side wall of the cavity, and when the movable part and deadbolt are in combinations of remaining positions and stations, the end of the deadbolt leaves the cavity;
the second holding mechanism is configured to be capable of holding the deadbolt at the first station, and when the deadbolt protrudes into the cavity and the end of the deadbolt is subjected to an external force that is vertically downward, the deadbolt is capable of overcoming constraints of the second holding mechanism to be switched to the station two.

10. The backpack garden tool system according to claim 9, wherein, the movable part is hinged with the base, the first holding mechanism comprises a blocking part slidably connected with the base, the blocking part is slidable between a holding station and a releasing station along a sliding direction, when the blocking part is at the holding station, the blocking part blocks the movable part at the first position to limit the movable part at the first position, and when the blocking part is at the releasing station, the blocking part leaves a swinging path of the movable part, so that the movable part is capable of swinging to the second position.

11. The backpack garden tool system according to claim 10, wherein, a first elastic unit is arranged between the blocking part and the base, a releasing button is attached to the blocking part, the deadbolt is slidably connected with the movable part; and the second holding mechanism is a second elastic unit arranged between the deadbolt and the movable part.

12. The backpack garden tool system according to claim 7, wherein, the second garden tool is a blower, and the blower comprises:
an air duct;
a driving module, arranged in the air duct, and provided with an output shaft;
an impeller, arranged on the output shaft of the driving module, and rotating around an axis of the output shaft;
a cover casing, accommodating an electronic component therein;
a first vent, communicating an inner cavity of the cover casing with the air duct; and
a second vent, communicating the inner cavity of the cover casing with air.

13. The backpack garden tool system according to claim 12, wherein, the air duct comprises an air inlet and an air outlet, the first vent is arranged at the air inlet and communicates with the air inlet, the cover casing is mounted on an outer wall of the air duct and is provided with a common wall with the air duct, the first vent is formed on the common wall, the cover casing is located on a lower side of the air duct, and a drainage port is arranged at a bottom of the cover casing.

14. The backpack garden tool system according to claim 13, wherein, the drainage port comprises a first drainage port located below the first vent and a second drainage port arranged adjacent to the second vent, a first water baffle and a second water baffle are arranged in the cover casing, the electronic component is mounted between the first water baffle and the second water baffle, the first vent and the first drainage port are located on one side of the first water baffle opposite to the electronic component, the second vent and the second drainage port are located at one side of the second water baffle opposite to the electronic component, an upper end of the first water baffle is provided with a first air hole, an upper end of the second water baffle is provided with a second air hole, a heat dissipation block is provided in the cover casing, the electronic component is mounted at a lower end of the heat dissipation block, and the first air hole and the second air hole are located above two ends of the heat dissipation block.
